(19)

Europäisches
Patentamt
European
Patent Office
Office européen
des brevets

(11) **EP 2 677 849 A1**

(12) **EUROPEAN PATENT APPLICATION**

(43) Date of publication:
   **25.12.2013 Bulletin 2013/52**

(51) Int Cl.:
   **H05K 7/20** (2006.01)

(21) Application number: **13425079.4**

(22) Date of filing: **29.05.2013**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(30) Priority: **20.06.2012 IT RM20120288
   13.08.2012 IT RM20120411**

(71) Applicant: **C.I.S. Sud s.r.l.
   00040 Ariccia (RM) (IT)**

(72) Inventor: **Bernardini, Giuseppe
   00040 Ariccia (RM) (IT)**

(74) Representative: **Santi, Filippo et al
   Barzano' & Zanardo Roma S.p.A.
   Via Piemonte 26
   00187 Roma (IT)**

(54) **Base transceiver station of a radio mobile telephone network, provided with a geothermal integrated conditioning system**

(57)    The present invention concerns a base transceiver station of a radio mobile telephone network, comprising a cabinet or booth called shelter (3) of housing therein a plurality of transceiving apparatuses, means for supplying electric power and means for air conditioning, according to which said means for air conditioning comprise a heat exchanger (4, 4') inside which a thermal fluid flows within a cooling circuit connected to means of passive dissipation of heat of the geothermal type (14, 14') and according to which air to be cooled is forcibly conveyed towards said heat exchanger (4, 4').

**EP 2 677 849 A1**

**Description**

The present invention concerns a base transceiver station of a radio mobile telephone network, provided with a geothermal integrated conditioning system.

The invention refers to the field of telecommunication and more in particular to the field of infrastructures for radio signal transmission of a radio mobile telephone network.

It is known that the radio mobile telephone network is essentially composed of transceiver stations of the radio mobile signal, called base transceiver station or, with english acronym BTS (Base Transceiver Station), equipped with a transceiving antenna serving users mobile terminals covering a specific geographical area called "radio cell", representing the center of a virtual "umbrella" coverage of radio signals.

So many "umbrellas" located near to each other set the geographical distribution of base stations, which are necessary for full coverage of the same, wherein the mobile service is realized.

The base stations are connected to the closer telephone exchange through optical cables and therefore placed over the entire transport fixed network.

The user's radio mobile terminal, lying within a radio cell, automatically transmits its presence at its base transceiver station.

In this situation, the user's radio mobile terminal is in the network and can be connected to communicate with any other user of the same telephone network.

In substance, the base transceiver station constitutes therefore the base of the cellular telephony infrastructure, used in radio connections of mobile cellular networks at the radio interface of the cellular system.

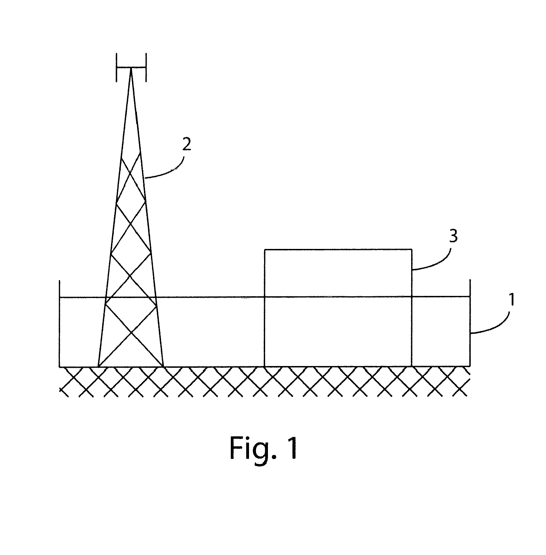

Referring to Figure 1, a base transceiver station typically consists of a small area of land fenced 1, inside which there are a plurality of transceiving antennas placed on a trestle 2 and a cabinet or booth called shelter 3.

The shelter 3 contains inside the transceiving apparatuses, the power station of electricity and that of refrigeration. Into the container 3 are also contained other complementary elements of service for the operation of the whole system.

The transceiving apparatuses comprise active electronic elements that dissipate energy and that work well within a limited range of ambient temperature, comprised between -5 °C and +65 °C.

The power station of electrical energy is generally connected to the electric network, from which it receives the energy which is then transmitted to the transceiving apparatuses, or, as happens for rural radio base stations, which are the greater part, is connected to a local self-generator group.

The station of refrigeration is generally constituted by two complexes refrigerants, connected in tandem, which allow the proper functioning of the active equipment, adjusting the required ambient conditioning of the shelter 3.

The air conditioning becomes very important especially for the summer season, but the same problem recurs even in winter, albeit to a lesser extent.

The proposed solutions according to the prior for the air conditioning of a base transceiver station encompass many disadvantages of both technical and economic nature, such as the ones listed below:

- power costs of refrigeration machines for tens of kW/h per day;
- costs even higher for the eventual use of energy produced locally;
- the purchase cost of refrigerating machines;
- costs for the space inside the shelter, occupied by refrigerating machines and no longer available for transmitting equipment of any other operators;
- maintenance costs for refrigerating machines;
- extraordinary maintenance costs of moving mechanical parts of refrigerating machines;
- so called social costs, such as environmental pollution and the invasive interventions of maintenance with congestion of urban traffic.

In this context it is included the solution according to the present invention, which aims to eliminate all the drawbacks described above, through a heat exchange system that uses a heat carrier fluid flowing inside a coil housed inside a shell, the air of the shelter being forced through said shell and then to come into contact with the coil due to the action of a fan (turbo system refrigerator), integrated with a passive heat dissipation device, which uses the geothermal energy of the ground in the area in which the base transceiver station is located.

Purpose of the present invention is therefore to provide a base transceiver station of a radio mobile telephone network equipped with a geothermal integrated conditioning system that allows to overcome the limitations of air-conditioning systems according to the prior art and to obtain the technical results previously described.

Further object of the invention is that said base transceiver station can be realized with substantially limited costs, both as regards production costs and, in particular, as regards the operating costs, given the location of the radio base stations, distributed throughout, and their deterioration for the continuous operation over time.

Not least object of the invention is to propose a base transceiver station equipped with a conditioning system of the turbo refrigerator type geothermal integrated that is simple, safe and reliable.

It is therefore a specific object of the present invention a base transceiver station of a radio mobile telephone network, comprising a cabinet or booth called shelter for housing therein a plurality of transceiving apparatuses, means for supplying electric power and means for air conditioning, in which said means for air conditioning comprise a heat exchanger inside which a thermal fluid within a cooling circuit flows connected to means of passive dissipation of heat of the geothermal type and according to which air to be cooled is forcibly conveyed towards said heat exchanger.

Preferably, according to the invention, said heat exchanger is positioned on the ceiling of said shelter and anyway in an area free of physical obstacles.

Alternatively, according to the present invention, said heat exchanger comprises at least one coil, or a tube bundle, inside which said thermal fluid flows, arranged within a shell, air being forced to pass through said shell.

Preferably, according to the invention, air is forced to pass through said shell by an axial fan.

Furthermore, according to the invention, said means of passive dissipation of heat of the geothermal type have high thermal inertia and preferably comprise at least one geothermal probe, more preferably a vertical geothermal probe (14).

In particular, according to the invention, said thermal fluid reaches the vertical geothermal probes through an inlet conduit, ending at the top of the probe, and leaves the geothermal probe through an outlet conduit, starting from the lower part of the probe.

The present invention will now be described, for illustrative but not limitative purposes, according to its preferred embodiments, with particular reference to the figures of the accompanying drawings, in which:

- Figure 1 shows a schematic elevation view of a base transceiver station,
- Figure 2 shows a schematic view of a heat exchanger type turbo refrigerator of a base transceiver station of a radio mobile telephone network, provided with a geothermal integrated conditioning system according to a first embodiment of the present invention,
- Figure 3 shows a schematic view of a vertical geothermal probe of a base transceiver station of a radio mobile telephone network, provided with a geothermal integrated conditioning system according to a first embodiment of the present invention,
- Figure 4 shows a schematic view of a heat exchanger type turbo refrigerator of a base transceiver station of a radio mobile telephone network, provided with a geothermal integrated conditioning system according to a second and preferred embodiment of the present invention, and
- Figure 5 shows a schematic view of a vertical geothermal probe of a base transceiver station of a radio mobile telephone network, provided with a geothermal integrated conditioning system according to a second and preferred embodiment of the present invention.

It is known that the temperature of the ground, starting from the ground level, is always less variable with depth, until it becomes almost constant, reaching a characteristic depth, which depends on the constitutional nature of the soil itself. In practice it can be assumed with good approximation that the ground, at a given depth, remains at a constant temperature throughout the year.

It is possible to exploit this natural aspect to cool a heat transfer fluid (water and ethylene glycol) of an air conditioning system realized within a base transceiver station.

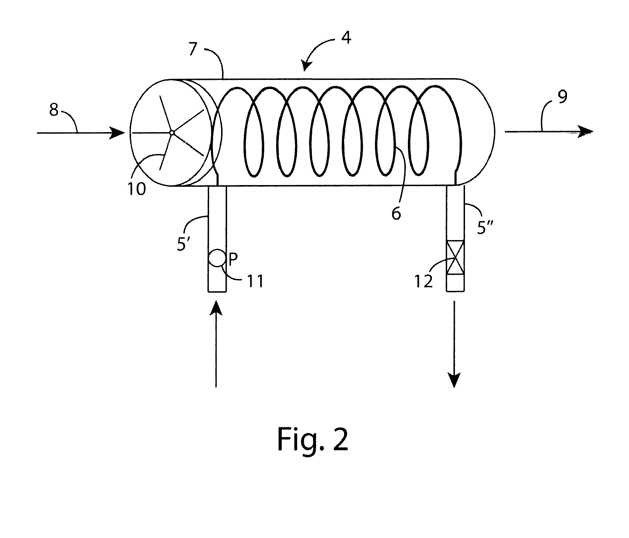

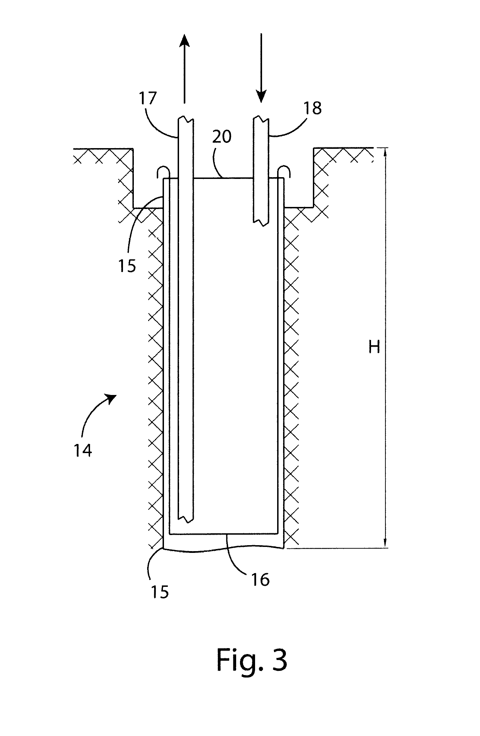

In this regard, Figure 2 shows, for illustrative but not limitative purposes, an air conditioning system of the temperature inside a base transceiver station realized according to the present invention, namely of type turbo refrigerator made for connection with a vertical geothermal probe (not shown in Figure 2, but which will be illustrated below with reference to Figure 3) for the exchange of heat with the ground. In particular, Figure 2 shows a heat exchanger 4 through a thermal fluid and the air of the shelter 3, the temperature of which must be conditioned so as to remain within values such as to guarantee the perfect functioning of the transceiving equipment housed in the shelter 3 . In particular, the heat exchanger 4 is placed on the ceiling of the shelter 3, or in an area free of physical obstacles (such as those constituted by the transceiving apparatuses) that might prevent the conveyance towards the heat exchanger 4 of the air contained in the various areas 3 of the shelter and in an elevated area to facilitate the flow of air heated by heat developed by said apparatus, which naturally tends upwards.

The thermal fluid is preferably water, optionally containing additives such as ethylene glycol or other antifreeze additive, to prevent that the water can freeze in particularly cold periods.

The thermal fluid reaches the heat exchanger 4 by an inlet conduit 5' and exits the heat exchanger 4 from an outlet conduit 5", flowing in a coil 6, arranged Within a cylindrical shell 7.

The air contained in the shelter 3 enters the cylindrical shell 7 by a input side 8 and exits from an output side 9, conveyed by an axial fan 10. In the embodiment shown with reference to Figure 2, for illustrative and not limitative purposes of the present invention, the air passes through the heat exchanger 4 co-current to the thermal fluid, which enters the heat exchanger 4 on the same side from which the thermal fluid enters through the inlet conduit 5', and exits the heat exchanger 4 from the same side from which the thermal fluid exits through the outlet conduit 5". Nevertheless, in an alternative embodiment, the air can pass through the heat exchanger 4 in countercurrent to the thermal fluid, or enter into the heat exchanger 4 from the same side from which the thermal fluid exits and exit the heat exchanger 4 from the same side from which the thermal fluid enters.

The circuit of the thermal fluid (which comprises the inlet conduit 5' in the heat exchanger 4, the outlet conduit 5" from the heat exchanger 4 and the coil 6, but also the remaining part of the circuit of junction with the vertical geothermal probe integrated to the air conditioning system according to the present invention), is preferably constituted by a flexible tube (which by way of example but not limitation can be realized in high density polyethylene netting, to ensure high homogeneity of heat exchange and long duration of operation).

The circuit of the thermal fluid is also provided with a pump 11, arranged upstream of the shell 7 in the sense of circulation of the thermal fluid, for the forced circulation of the fluid, and a check valve 12, disposed downstream of the shell 7 in the sense of movement of the thermal fluid, for adjusting the motion of the same.

Finally, with reference to Figure 3, there is shown a vertical geothermal probe for use in the base transceiver station of a radio mobile telephone network, provided with a geothermal integrated conditioning system according to the present invention. Indicated as a whole by the reference number 14, said vertical geothermal probe is a device for heat exchange between a fluid flowing inside the probe 14 and the surrounding earth, the probe being inserted into a vertical hole specially made in depth in the area surrounding the shelter 3. According to the present invention, the fluid flowing inside the probe 14 is the thermal fluid of the hydraulic circuit connected to the heat exchanger 4 type turbo refrigerator illustrated above with reference to Figure 2.

The vertical geothermal probe 14 is made by placing a shell 15 (which by way of example but not limiting can be made of steel or plastic material) in a vertical hole excavated in depth in the ground. The shell 15 can be constituted by individual sizes joined together mechanically and / or interlocking and its tightness is obtained by a plastic sheath 16, arranged inside the shell 15 and having the same shape and diameter of the interior of shell 15.

The depth of insertion into the ground of the shell 15 depends on the nature of the soil itself and is determined based on the value of the temperature (geothermal energy), which can be considered constant in depth, and the need for air-conditioning system.

At the deep end the shell 15 and the sheath 16 are closed and are filled with the thermal fluid of the hydraulic circuit of the heat exchanger 4 type turbo refrigerator illustrated above with reference to Figure 2. The thermal fluid arrives in the geothermal probe 14 through the inlet conduit 18, which ends at the head of the shell 15, and leaves the geothermal probe 14 through the outlet conduit 17, which starts from the base of the deep inner shell 15.

In particular, the vertical geothermal probe can be made with large containment capacity of thermal fluid. This results in a high thermal inertia of the geothermal system. The thermal inertia is particularly important in air conditioning of all the peak temperatures which often occur in the performance of radio base stations.

A first important feature of the integrated geothermal conditioning system according to the present invention is its functional efficiency, ie its capacity to ensure the obtaining of maintaining the temperature within the shelter to the levels required for the operation of the transceiving apparatuses.

Moreover, so that it may be applied, the integrated geothermal conditioning system according to the present invention must be reliable and cost-effective in operation compared to other known systems.

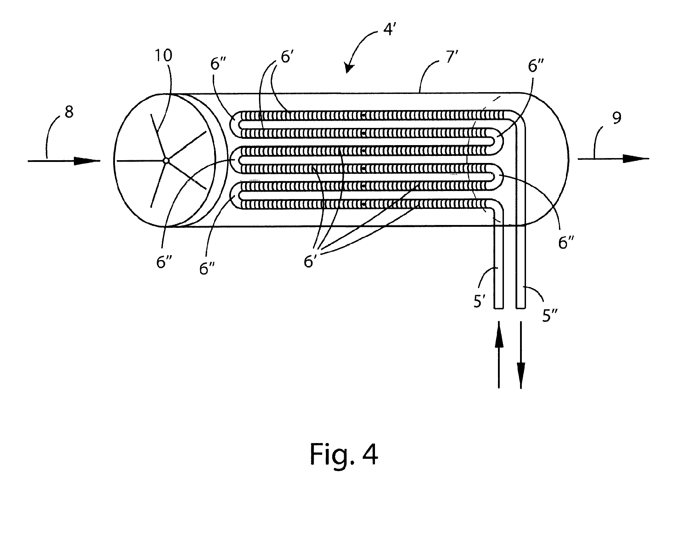

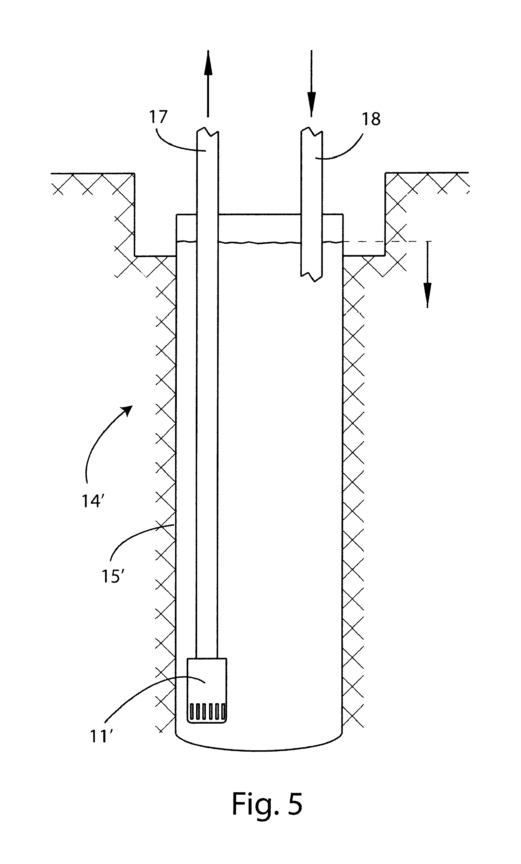

Figures 4 and 5 show a system of temperature conditioning of the inside of a base transceiver station realized according to a second preferred embodiment of the present invention, which has the purpose of ensuring still better the obtaining of the above-mentioned requirements, through structural changes and operation of three basic elements of the system.

The first variant, as compared to the air conditioning system shown with reference to Figures 2 and 3, is to predict that the heat exchanger turbo refrigerator, in figure 4 indicated by the reference number 4', comprises, inside a cylindrical shell, a tube bundle comprised of tubes 6' that develop mainly in the direction parallel to the axis of the cylindrical shell 7'.

The tubes 6' are arranged in battery and are connected together at the ends by means of U-shape fittings 6" to form a unique path for the thermal fluid inside the cylindrical shell 7'.

Each tube 6' is externally provided with fins arranged in a way forming an elix, so as to convey the flow of air to be cooled along the outer surface of the heat exchange tubes 6'.

The final result that is obtained is a high increase in the area of heat exchange between air (hot) that passes outside of the tubes 6' and thermal fluid (cold) that passes inside the tubes 6' of the heat exchanger 4'; which involves a high cooling efficiency of the system, even with a thermal differential between air and thermal fluid equal to a few degrees.

For the rest, the characteristics of the heat exchanger 4' according to this variant of the heat exchanger correspond to those shown with reference to Figure 2, the thermal fluid arriving at the heat exchanger 4' by an inlet conduit 5' and exiting from heat exchanger 4' by a outlet conduit 5" and the air contained in the shelter 3 entering the shell 7' by a cylindrical input side 8 and exiting from an exit side 9, conveyed by an axial fan 10.

The second variant concerns the pump of the hydraulic circuit of the thermal fluid that, according to this embodiment, is not arranged upstream of the shell 7' in the sense of circulation of the thermal fluid, but rather, as is shown with reference to Figure 5, is a pump of the submerged type, indicated by the reference number 11', placed on the bottom of the shell 15' of the geothermal probe 14', at the mouth of the outlet conduit 17.

This solution offers a number of advantages compared to the one shown with reference to Figures 2 and 3, and in particular: does not occupy space within the shelter 3 and does not generate noise of operation within the shelter 3 itself.

Furthermore, this solution does not require an expansion tank for the hydraulic circuit of the thermal fluid and even of a directional valve for the movement of the hydraulic flow and a check valve for the initial departure of the flow.

Not only that, the submerged pump 11' is also self protected from failure in the absence of hydraulic fluid in the circuit and requires a lower prevalence compared to that of a suction pump of the same class, since it is compensated by the piezometric height of the geothermal probe 14'.

A further particularly important advantage consists in the fact that the solution according to this embodiment allows to reduce the speed of the hydraulic flow, without compromising the functionality of the pump, so as to increase the time of heat exchange between air and thermal fluid in the heat exchanger 4' and between thermal fluid and land in the geothermal probe 14'.

Finally, the geothermal probe 14' is preferably made with a thin wall shell 15' of metal, more preferably steel, to reduce the time to restore the temperature of the thermal fluid as a consequence of heat exchange with the ground at a lower temperature inside the geothermal probe 14'.

The choice of steel, suitably protected from corrosion, depends on the fact that the heat exchange coefficient of this material is of the order of about 100 times higher than that of other materials economically usable for the construction of the shell 15' of the geothermal probe 14' which were considered (PVC, PTH and other polymeric materials).

For the rest, the vertical geothermal probe 14' for use in the base transceiver station of a radio mobile telephone network, provided with a geothermal integrated conditioning system according to the embodiment of the present invention shown with reference to Figure 5 corresponds to that shown with reference to Figure 3, the shell 15 may be made up of single pieces joined together mechanically and/or interlocking, provided it always maintain its hydraulic seal for its entire length, both to contain the thermal fluid throughout its volume, but also to contribute to the increase of the cooling capacity of the system, the thermal fluid arriving in the geothermal probe 14' through the inlet conduit 18, which ends at the head of the shell 15, and out of the geothermal probe 14' through the outlet conduit 17, which starts from the base deep inside of the shell 15'.


Example 1. Dimensioning of the heat exchanger and the relative devices for forced conveyance

Referring by way of example but not limiting to the first embodiment of the present invention, namely the one shown with reference to Figures 2 and 3, for the sizing of the heat exchanger 4 type turbo refrigerator intended for the temperature conditioning of the air inside the shelter 4 the extreme conditions of temperature were considered, ie a temperature inside the shelter Ti equal to 65 °C (maximum allowable for proper operability of the transceiving apparatuses) and a temperature outside the shelter Te equal to 45 °C, temperature maximum of the external environment in the summer period, statistically determined based on the geographical location of the base transceiver station.

The amount of heat to be absorbed by the thermal capacity of the air contained in the shelter, the volume of the shelter being set equal to 15 $m^3$ and considered for the air a specific value equal to average 0,316Cal/$m^3$ °C, is calculated as

$$Q = cp \cdot V \cdot \Delta T$$

$$Q = 0{,}316 \cdot 15 \cdot (65 - 45) = 94{,}8 \text{ Cal}$$

The amount of heat to be absorbed by the wall of the coil is determined by the relation

$$Q = \alpha \cdot k \cdot S \cdot (Ti\text{-}Te)$$

wherein:

$\alpha$ is the coefficient of the form of the system, which for simplicity of calculation is assumed equal to 1;
k is the coefficient of heat exchange (in Cal/m$^2$ °C) of a metal wall and is assumed equal to 9;
S is the outer surface of the wall of the coil (expressed in square meters),
from which it is obtained

$$Q = 1 \cdot 9 \cdot S \cdot 20 = 180\ S$$

$$S = 94{,}8/180 = 0{,}53\ m^2$$

For a metal tube with a diameter of 16 mm the length of the coil is obtained by the relation

$$S = D \cdot \pi \cdot L$$

in which:

S is the outer surface of the wall of the coil (expressed in square meters);
D is the outer diameter of the coil (expressed in meters),
n is the constant of Archimedes (dimensionless) and L is the length of the coil (expressed in meters),

$$S = 16 \cdot 10^{-3} \cdot 3{,}14 \cdot L$$

$$L = 0{,}53/16 \cdot 10^{-3} \cdot 3{,}14 \approx 10\ m$$

Doing the same calculation of the length of the coil for a tube with a diameter of 16 mm of a material especially used in this field, type PEXAL, whose thermal conductivity (indicated by the manufacturer, the company Valsir of Brescia), is equal to

$$Ct = 0{,}42\ W/m \cdot 10^3\ °C;$$

or, expressed in Cal/h·m·°C is

$$Ct = 0{,}42 \cdot 3600Cal/3600s \cdot m \cdot 10^3 \cdot °C$$

$$= 0{,}42 \cdot 3{,}6\ Cal/h \cdot m \cdot °C$$

The amount of heat to be absorbed is expressed by the relation

$$Q = \alpha \cdot Ct \cdot (65 - 45)$$

$$Q = \alpha \cdot 0{,}42 \cdot 3{,}6 \cdot L \cdot (65 - 45)$$
$$= 0{,}5 \cdot 0{,}42 \cdot 3{,}6 \cdot L \cdot 20$$
$$= 15{,}12 \cdot L$$

From which

$$94{,}8 = 15{,}12 \cdot L$$

$$L = 94{,}8/15{,}12 \approx 6 \text{ m}$$

Considering a coil of average length between the two previously determined, ie 8m long, the initial water temperature (geothermal energy) being set equal to 15 °C,
the final temperature of the water Tx, after passing through the coil is obtained by the relation

$$Q = \alpha \cdot Ct \cdot L \cdot (Tx - 15)$$
$$= 0{,}5 \cdot 0{,}42 \cdot 3{,}6 \cdot 8 \cdot (Tx - 15)$$
$$= 6{,}05 \cdot (Tx - 15)$$

from which

$$94{,}8 = 6{,}05 \cdot Tx - 90{,}75$$

$$Tx = 94{,}8 + 90{,}75/6{,}05 = 185{,}55/6{,}05 \approx 31 \text{ °C.}$$

The increase of the water temperature, as thermal fluid is

$$\Delta T = 31 - 15 = 16 \text{ °C}$$

The coil is housed in a metal shell of length L = 1 m. To calculate the diameter of this shell the following assumptions were made: the shell contains 8 elements of the coil, considering that each element occupies a virtual area inside the tube equal to 3 times its diameter, it is obtained, for the calculation the diameter of the metal shell D:

$$d = \text{diameter of one of the eight virtual elements of the coil}$$
$$= 16 + 16 + 16 = 48 \text{ mm}$$

Section of a virtual element

$$24 \cdot 24 \cdot \pi = 1808{,}64 \text{ mm}^2$$

Section of the metal shell

$$1808{,}64 \cdot 8 = 14469{,}12 \text{ mm}^2$$

$$14469{,}12/\Pi \approx 4608 \text{ mm}^2$$

$$D = 2 \cdot \sqrt{4608} = 135{,}76 \approx 200 \text{ mm}$$

The diameter of the metallic shell is then chosen equal to 200 mm. The pressure drop in the shell $Y_t$ (in kg/m$^2$) is calculable through the relation

$$Y_t = 6{,}61 \cdot v^{1{,}924}/D^{1{,}281} \cdot L$$

in which:

v is the velocity (in m/s) in the shell, which is assumed as an average = 4m/s;
D is the diameter of the shell already found, equal to 200mm,

$$Y_t = 6{,}61 \cdot 4^{1{,}924}/16^{1{,}281} \cdot 1$$
$$= 6{,}61 \cdot 16/26 \approx 4 \text{ kg/m}^2$$

The air flow rate in the shell is calculated from the relationship $P_a = 3600 \cdot 10^{-6} \cdot \Pi \cdot v \cdot D^2/4$ m$^3$/h, in which:

v is its velocity of the air = 4 m/s;
D is the diameter of the shell = 200mm,

$$P_a = 45216 \cdot 10^{-6} \cdot 200^2/4$$
$$= 45216 \cdot 10^{-6} \cdot 4 \cdot 10^4/4 \approx 450 \text{ m}^3/\text{h}$$

The rate of air change per hour of the shelter is obtainable by dividing the air flow $P_a$ for the volume of the shelter, which is equal to 450/15 = 30h$^{-1}$

The minimum power of the axial fan necessary to ensure the turbo feature of the heat exchanger, causing the excess pressure thrust air inside the shell can be calculated by the equation:

N = V · $Y_t$/3600 · 75 · η CV (see Manual Colombo), in which:
N is the minimum power of the fan (in W);
$P_a$ is the air flow in the shell (in m$^3$/h), $Y_t$ is the pressure drop in the shell, already previously determined and equal to 4kg/m$^2$
η is the efficiency of the engine, which it is assumed, precautionarily, amounting to 0,3
CV is the unit of measure in horsepower.

$$N = 450 \cdot 4/3600 \cdot 75 \cdot 0,3 \text{ hp}$$

$$= 1800/81000 = 0,022 \text{ CV} = 0,022 \cdot 735 \approx 16 \text{ W}$$

The calculation of the flow $Q_a$ of water in the hydraulic circuit, including the coil, is given by:

The volume of the circuit is

$$S \cdot L = r \cdot r \cdot 3,14 \cdot L = 0,10 \cdot 0,10 \cdot 3,14 \cdot 250 = 7,85 \text{dm}^3,$$

in which:

r is the radius of the circuit tubing = 0,1 dm:
L is the length of the hydraulic circuit = 250 dm.
It is considered a water velocity v = 1 m/s

The time (in seconds) that the water employs to travel around the circuit in its entire length (L in meters) is equal to t = L/v = 25/1 = 25 s.

$$Q_{a} = 7,85 \text{dm}^3/25 \text{ s} = 0,314 \text{ dm}^3/\text{s} = 0,314 \cdot 60 \text{ dm}^3/\text{min}$$

$$\approx 19 \text{ dm}^3/\text{min} = 19 \cdot 60 = 1140 \text{ dm}^3/\text{h}.$$

The pump needed for circulating water in the hydraulic circuit, including the coil, will have a prevalence equal to:

$\varepsilon = Y_a \cdot L + \text{HMS} + \text{HMA}$, in which
$Y_a = 0,20$ kg/min$^2$. min, is the pressure drop of the water of the hydraulic circuit for the hourly flow rate of 1140 dm$^3$/h and per meter of pipe (L=25m);
HMS = 2 m = 0,2 kg/m$^2$ is the maximum height of thrust, due to the maximum height of the circuit from the pump.
HMA = 12 m = 0,2 kg/m$^2$ is the maximum suction height, due to the maximum depth of the circuit from the pump.

Substituting the values

$$\varepsilon = 0,20 \cdot 25 + 0,2 + 0,2 \approx 5,4 \text{kg/m}^2.$$

The present invention has been described for illustrative but not limitative purposes, according to its preferred embodiments, but it is to be understood that variations and/or modifications can be made by the skilled in the art without departing from the scope of protection, as defined by the appended claims.

**Claims**

1. Base transceiver station of a radio mobile telephone network, comprising a cabinet or booth called shelter (3) for housing therein a plurality of transceiving apparatuses, means for supplying electric power and means for air conditioning, **characterised in that** said means for air conditioning comprise a heat exchanger (4, 4') inside which a thermal fluid flows within a cooling circuit connected to means of passive dissipation of heat of the geothermal type (14, 14') and according to which air to be cooled is forcibly conveyed towards said heat exchanger (4, 4').

2. Base transceiver station according to claim 1, **characterised in that** said heat exchanger (4, 4') is positioned on the ceiling of said shelter (3) and anyway in an area free of physical obstacles.

3. Base transceiver station according to claim 1 or 2, **characterised in that** said heat exchanger (4) comprises at least one coil (6), inside which said thermal fluid flows, arranged within a shell (7), air being forced to pass through said shell (7).

4. Base transceiver station according to claim 1 or 2, **characterised in that** said heat exchanger (4') comprises a tube bundle comprised of tubes (6'), inside which said thermal fluid flows, arranged within a shell (7'), air being forced to pass through said shell (7'), said tubes (6') developping mainly in a direction parallel to the axis of said cylindric shell (7') and being connected to one another at their ends by means of U-shaped connectors (6"), so to form a unique path for the thermal fluid inside the shell (7').

5. Base transceiver station according to claim 4, **characterised in that** each tube (6') is externally provided with fins arranged in a way forming an elix.

6. Base transceiver station according to claims 3, 4 or 5, **characterised in that** air is forced to pass through said shell (7, 7') by an axial fan (10).

7. Base transceiver station according to any of the preceding claims, **characterised in that** said means of passive dissipation of heat of the geothermal type (14, 14') have high thermal inertia.

8. Base transceiver station according to any of the preceding claims, **characterised in that** said means of passive dissipation of heat of the geothermal type (14, 14') comprise at least one geothermal probe.

9. Base transceiver station according to claim 8, **characterised in that** said geothermal probe is a vertical geothermal probe (14, 14').

10. Base transceiver station according to claim 9, **characterised in that** said thermal fluid reaches the vertical geothermal probe (14, 14') through an inlet conduit (18), ending at the top of the probe, and leaves the geothermal probe (14, 14') through an outlet conduit (17), starting from the lower part of the probe, at the entrance of said outlet conduit (17) being arranged a submerged pump (11').

Fig. 1

Fig. 2

Fig. 3

Fig. 4

Fig. 5

Europäisches
Patentamt

European
Patent Office

Office européen
des brevets

# EUROPEAN SEARCH REPORT

Application Number

EP 13 42 5079

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 538 883 B1 (GREER STEPHEN [US]) 25 March 2003 (2003-03-25) * abstract * * figures 1-3 * * column 1, lines 15-23 * * column 2, line 55 - column 7, line 33 * | 1-10 | INV. H05K7/20 |
| X | FR 2 774 520 A1 (POUYET SA [FR]) 6 August 1999 (1999-08-06) * page 1, line 3 - page 4, line 19; figure 1 * | 1-10 | |
| X | WO 93/23875 A1 (GEOTECH ENERGY CONVERSION CORP [US]) 25 November 1993 (1993-11-25) * page 3, line 1 - page 6, line 27 * * page 10, line 20 - page 14, line 3 * * figures 1-3 * | 1-10 | |
| X | EP 1 755 368 A2 (ISOLECTRA B V [NL]) 21 February 2007 (2007-02-21) * figures 1-4 * * paragraphs [0002], [0003], [0004], [0023] - [0025] * | 1-10 | TECHNICAL FIELDS SEARCHED (IPC) H05K |

The present search report has been drawn up for all claims

| Place of search | Date of completion of the search | Examiner |
|---|---|---|
| The Hague | 14 October 2013 | Kaluza, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 42 5079

This annex lists the patent family members relating to the patent documents cited in  the above-mentioned European search report.
The members are as contained in the European Patent Office EDP file on
The European Patent Office is in no way liable for these particulars which are merely given for the purpose of information.

14-10-2013

| Patent document cited in search report | | Publication date | Patent family member(s) | | Publication date |
|---|---|---|---|---|---|
| US 6538883 | B1 | 25-03-2003 | US 6538883 B1<br>US 6804114 B1 | | 25-03-2003<br>12-10-2004 |
| FR 2774520 | A1 | 06-08-1999 | AU 2059899 A<br>FR 2774520 A1<br>WO 9939415 A1 | | 16-08-1999<br>06-08-1999<br>05-08-1999 |
| WO 9323875 | A1 | 25-11-1993 | AU 4112993 A<br>CA 2135762 A1<br>EP 0640246 A1<br>WO 9323875 A1 | | 13-12-1993<br>25-11-1993<br>01-03-1995<br>25-11-1993 |
| EP 1755368 | A2 | 21-02-2007 | EP 1755368 A2<br>NL 1029750 C2 | | 21-02-2007<br>20-02-2007 |

EPO FORM P0459

For more details about this annex : see Official Journal of the European Patent Office, No. 12/82